# EUROPEAN PATENT APPLICATION

(11) **EP 2 690 791 A1**
(43) Date of publication of application: **29.01.2014**
(21) Application number: 12178270.0
(22) Date of filing: 27.07.2012
(51) Int. Cl.: H03M 13/27, H03M 13/11, H03M 13/25

(54) **Component interleaving for rotated constellations with quasi-cylic LDPC codes**

(71) Applicant: Panasonic Corporation, Osaka 571-8501 (JP)
(72) Inventor: Petrov, Mihail, 63225 Langen (DE)
(74) Representative: Grünecker, Kinkeldey, Stockmair & Schwanhäusser

(57) **Abstract**

The present invention relates to communication systems that employ rotated constellations in conjunction with quasi-cyclic LDPC codes, and provides a component interleaver that is optimized for a particularly efficient hardware implementation.

## Description

### TECHNICAL FIELD

The present invention relates to the field of digital communications and more specifically to communication systems that employ rotated constellations in conjunction with quasi-cyclic LDPC codes.

### BACKGROUND OF THE INVENTION

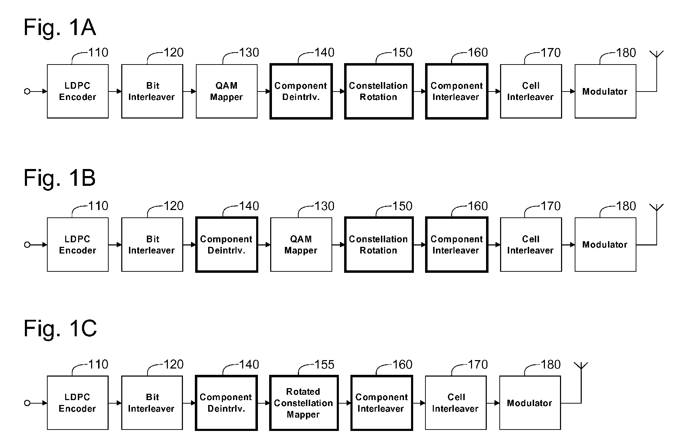

Figure 1A shows the block diagram of a generic transmitter that employs rotated constellations in conjunction with quasi-cyclic LDPC codes. The diagram is simplified to include only those blocks which are relevant to the present invention.

The transmitter receives at its input binary blocks of a predetermined length, containing the information to be transmitted. Each information block is first encoded by an LDPC (low-density parity-check) encoder 110, the encoding process consisting in computing and adding redundancy bits in order to make the information block more robust against errors.

The bits of the encoded LDPC codeword, thereafter referred to as LDPC block, are then interleaved using a bit interleaver 120 and mapped onto complex QAM symbols by QAM mapper 130. The real and the imaginary components of the QAM symbols are modulated independently, each component encoding a predefined number of bits, denoted here by B. These two components can be regarded as PAM (pulse amplitude modulation) or ASK (amplitude shift keying) symbols, such a symbol taking a value from a discrete set of 2^{B} values. How the B bits are mapped to PAM symbols is well understood and not directly relevant to the present invention. The relevant aspect is that each FEC block is transformed into a block of real PAM symbols, which are paired into complex QAM symbols.

In order to increase the robustness over fading channels, a dedicated transformation is applied to the symbols generated by the QAM mapper 130, by multiplying vectors of D real PAM symbols by a DxD square orthogonal matrix. This transformation is performed by the constellation rotation block 150. The PAM symbols in each vector can be regarded as identifying unique points in a D-dimensional space, the resulting D^{B} combinations forming a D-dimensional constellation. The matrix multiplication can thus be regarded as a rotation in the D-dimensional space, hence the term rotated constellations. The particular structure of the rotation matrix is not relevant to the present invention.

In order to achieve good performance with rotated constellations it is essential that the D real components of each rotated constellation be mapped to D different complex symbols, which are also referred to as cells. Moreover, the D components must be spread in time and frequency so that the channel fading they experience is as uncorrelated as possible. These aspects are well understood in the art.

Referring to Figure 1A, the D components of each rotated constellation are first spread over a FEC block by the component interleaver 160. The cells of each FEC block are further spread in time and frequency by a time interleaver and a frequency interleaver, respectively. These interleavers are placed between the cell interleaver 170 and the modulator 180, but for the sake of clarity they are not shown.

Finally, the complex symbols are modulated and transmitted over the communication medium. The modulation scheme can be for example OFDM (orthogonal frequency-division multiplexing) and an additional interleaving in time and frequency is typically performed prior to modulation in order to increase the diversity of the system.

An alternative transmitter block diagram with identical functionality can be obtained if the component deinterleaver 140 is moved in front of the QAM mapper 130, as shown in Figure 1B, so that the component deinterleaving is applied to bits instead of complex cells. Such a configuration may lead to a more efficient implementation.

Furthermore, the QAM mapper 130 and the constellation rotation 150 can be combined into a single block which directly performs the mapping of groups of 2*B*D bits to rotated-constellation blocks, the combined block being referred to as rotated constellation mapper 155 in Figure 1C.

The structure in Figure 1A is the most clear and will be used for describing the transmitter functionality. Its advantages are: 1) that the component de-interleaver and interleaver are applied to cells, so they are very similar in structure, and 2) that their pairing is more clearly visible. For the understanding the receiver functionality, however, the mirrored version of the structure in Figure 1C is more suitable, for reasons that will be explained later.

It is the main goal of the present invention to disclose a novel component interleaver which is optimized to allow for a highly efficient hardware implementation.

In the following, some features of quasi-cyclic LDPC codes will be explained.

LDPC codes are linear error-correcting codes that are fully defined by a parity-check matrix (PCM), which is a binary sparse matrix that represents the connection of the codeword bits (also referred to as variable nodes) to the parity checks (also referred to as check nodes). The columns and the rows of the PCM correspond to the variable and the check nodes respectively. Connections of the variable nodes to the check nodes are represented by "1" entries in the PCM.

Quasi-cyclic (QC) LDPC codes have a structure that makes them particularly suitable for hardware implementation. In fact, most if not all standards today use quasi-cyclic LDPC codes. The PCM of such a code has a special structure consisting of circulant matrices (also referred to as circulants). A circulant is a square matrix in which each row is a cyclic shift of the previous row with one position, and can have one, two, or more cyclically-shifted diagonals. The size of each circulant is QxQ, where Q is referred to as the cyclic factor of the LDPC code. Such a quasi-cyclic structure allows Q check nodes to be processed in parallel, which is clearly advantageous for an efficient hardware implementation.

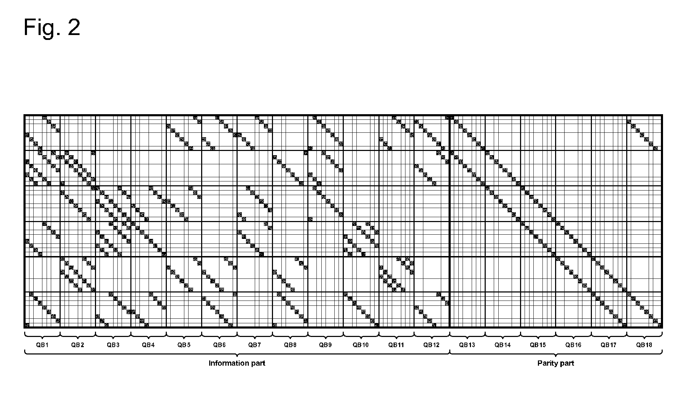

Fig. 2 shows the PCM of an example LDPC code with a cyclic factor Q=8, the PCM having circulants with one or two diagonals. This code encodes a block of 8x12=96 bits to a codeword of 8x16=128 bits, having therefore a code rate of 2/3. The codeword bits are subdivided into blocks of Q bits, which will be referred to as cyclic blocks or quasi-cyclic blocks and denoted by QB throughout this document.

The code whose matrix is illustrated in Figure 2 belongs to a special family of QC LDPC codes are the repeat-accumulate (RA) QC LDPC codes. These codes are well known for their ease of encoding and are encountered in a large number of standards, such as the second-generation DVB standards: DVB-S2, DVB-T2, and DVB-C2. For these codes the right-hand side of the PCM, which corresponds to the parity bits, has a staircase structure. These aspects are well understood.

In the following, some features of a specific type of bit interleaver that is specifically adapted to the structure of a QC LDPC block will be explained. This type of bit interleaver, which will be referred to as parallel bit interleaver, is characterized by a high degree of parallelism, which results in particularly efficient hardware implementations.

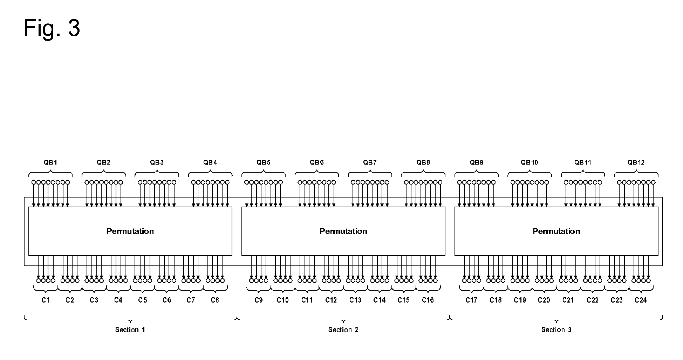

Fig. 3 shows the structure of an example parallel bit interleaver for an example LDPC code. In this example, the LDPC code has 12 QBs per codeword and 8 bits per QB (Q=8). As it is apparent from this figure, the QBs of an LDPC block are grouped into sections and each section is interleaved separately using a section permutation.

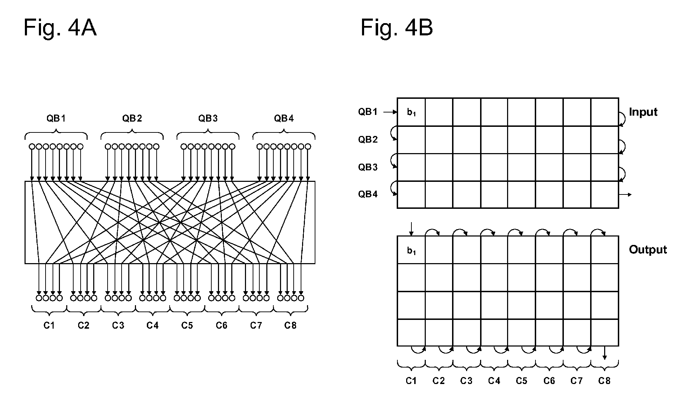

The section permutation is illustrated in greater detail in Figs 4A and 4B. The number of QBs per interleaving section (4 in this example) is a parameter of the interleaver and will be denoted by M throughout this document. The section permutation is performed conceptually by writing the Q*M bits of each section row by row into a matrix with M rows and Q columns and reading them out column by column; cf. Fig. 4B. Thus, the output of the section interleaver consists of groups of M bits, the M bits belonging to M different QBs of the original LDPC block.

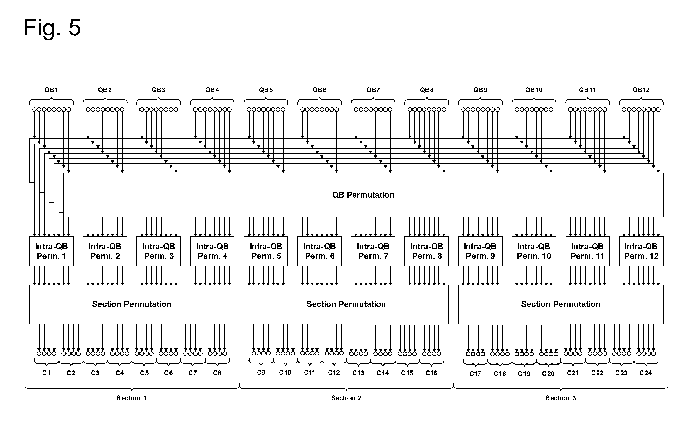

Prior to the grouping of the QBs into sections, the order of the QBs in the LDPC codeword can be changed according to a predefined permutation, referred to as QB permutation. Moreover, additional permutations can be applied to the Q bits of each QBs. These permutations are referred to as intra-QB permutations and are typically cyclic shifts, the shift value being different for each QB. The resulting structure is illustrated in Fig. 5.

While these two kinds of permutations are important for performance optimization, they are not directly relevant to the present invention. In fact, they can be regarded as part of the LDPC code definition. Thus, the QB permutation is equivalent to a permutation of the QB columns in the original PCM, whereas the intra-QB cyclic shifts increment modulo Q the original cyclic shifts of the diagonals in the PCM, the same cyclic shifts being applied to all diagonals in the same QB column.

### SUMMARY OF THE INVENTION

The main disadvantage of the prior-art solution is that the resulting component interleaver cannot be easily parallelized as its structure is not adapted to the quasi-cyclic structure of the LDPC code. The lack of parallelism prevents an efficient implementation, particularly for receivers that employ iterative decoding.

It is therefore the object of the invention to overcome the above problems and to provide an improved component interleaver that is inherently parallelizable.

This is achieved by the features as set forth in the independent claims. Preferred embodiments are the subject matter of dependent claims.

It is the particular approach of the present invention to adapt the structure of the component interleaver to that of the parallel bit interleaver.

According to a first aspect of the present invention, a method for transmitting a codeword of a quasi-cyclic low-density parity-check code in a digital communication system employing rotated D-dimensional constellations is provided. Each component of the D-dimensional constellations encodes B bits, the codeword consists of N cyclic blocks, and each cyclic block consists of Q bits. The method comprises the steps of dividing the codeword into N/(B*D) sections, each section consisting of M=B*D cyclic blocks; applying a bit permutation to the bits of each section and dividing each of the permuted sections into groups of B bits, wherein the bit permutation is adapted such that the Q bits of each cyclic block are mapped to Q different groups of B bits; mapping each group of B bits to a real-valued symbol, resulting in a sequence of D*Q real-valued symbols for each section; dividing each sequence of D*Q real-valued symbols into a plurality of D-dimensional vectors and transforming each of the D-dimensional vectors by multiplying the vector with an orthogonal matrix, resulting in a sequence of D*Q transformed real-valued symbols for each section; applying a first symbol permutation to each sequence of D*Q transformed real-valued symbols, the first symbol permutation being equivalent to writing the sequence of D*Q transformed real-valued symbols column-wise into a matrix with Q columns and D rows, applying cyclic shifts to the rows of said matrix, and reading the permuted sequence of D*Q transformed real-valued symbols row-wise from said matrix; generating a sequence of N*Q/(2B) complex-valued symbols by mapping each pair of two consecutive transformed real-valued symbols of each sequence of D*Q transformed real-valued symbols to a complex-valued symbol of the sequence of N*Q/(2B) complex-valued symbols; applying a symbol permutation to the sequence of N*Q/(2B) complex-valued symbols, the symbol permutation being equivalent to writing the sequence of complex-valued symbols row-wise into a matrix with Q/2 columns and N/B rows and reading out the permuted sequence of complex-valued symbols column-wise; and transmitting the permuted sequence of complex-valued symbols.

According to a further aspect of the present invention, a method for receiving a codeword of a quasi-cyclic low-density parity-check code is provided. Each component of the D-dimensional constellations encodes B bits, the codeword consists of N cyclic blocks, and each cyclic block consists of Q bits. The method comprises the steps of receiving a permuted sequence of N*Q/(2B) complex-valued symbols; applying an inverse symbol permutation to the permuted sequence of complex-valued symbols, the inverse symbol permutation being being equivalent to writing the sequence of complex-valued symbols column-wise into a matrix with Q/2 columns and N/B rows and reading out the permuted sequence of complex-valued symbols row-wise; generating N/(B*D) sequences of D*Q real-valued symbols by mapping a real part and an imaginary part of each complex-valued symbol of the sequence of N*Q/(2B) complex-valued symbols to a pair of two consecutive real-valued symbols of one of the sequences of D*Q real-valued symbols; applying a first symbol permutation to each sequence of real-valued symbols, the first symbol permutation being equivalent to writing the sequence of D*Q real-valued symbols row-wise into a matrix with Q columns and D rows, applying cyclic shifts to the rows of said matrix, and reading the permuted sequence of D*Q real-valued symbols column-wise from said matrix; dividing each permuted sequence of real-valued symbols into a plurality of D-dimensional vectors; de-mapping B*D bits from each D-dimensional vector, resulting in N/(B*D) sections, each section consisting of B*D*Q bits; retrieving the codeword by applying an inverse of a bit permutation to the bits of each section, wherein the bit permutation is adapted such that the Q bits of each cyclic block are mapped to Q different groups of B bits.

According to a further aspect of the present invention, a transmitter for transmitting a codeword of a quasi-cyclic low-density parity-check code in a digital communication system employing rotated D-dimensional constellations is provided. Each component of the D-dimensional constellations encodes B bits, the codeword consists of N cyclic blocks, and each cyclic block consists of Q bits. The transmitter comprises a bit interleaver adapted for dividing the codeword into N/(B*D) sections, each section consisting of M=B*D cyclic blocks, and for applying a bit permutation to the bits of each section and dividing each of the permuted sections into groups of B bits, wherein the bit permutation is adapted such that the Q bits of each cyclic block are mapped to Q different groups of B bits; a mapper adapted for mapping each group of B bits to a real-valued symbol, resulting in a sequence of D*Q real-valued symbols for each section; a constellation rotation unit adapted for dividing each sequence of D*Q real-valued symbols into a plurality of D-dimensional vectors and transforming each of the D-dimensional vectors by multiplying the vector with an orthogonal matrix, resulting in a sequence of D*Q transformed real-valued symbols for each section; a component interleaver (160) adapted for applying a first symbol permutation to each sequence of D*Q transformed real-valued symbols, the first symbol permutation being equivalent to writing the sequence of D*Q transformed real-valued symbols column-wise into a matrix with Q columns and D rows, applying cyclic shifts to the rows of said matrix, and reading the permuted sequence of D*Q transformed real-valued symbols row-wise from said matrix; a cell interleaver adapted for generating a sequence of N*Q/(2B) complex-valued symbols by mapping each pair of two consecutive transformed real-valued symbols of each sequence of D*Q transformed real-valued symbols to a complex-valued symbol of the sequence of N*Q/(2B) complex-valued symbols, and for applying a symbol permutation to the sequence of N*Q/(2B) complex-valued symbols, the symbol permutation being equivalent to writing the sequence of complex-valued symbols row-wise into a matrix with Q/2 columns and N/B rows and reading out the permuted sequence of complex-valued symbols column-wise; and a modulator adapted for transmitting the permuted sequence of complex-valued symbols..

According to a further aspect of the present invention, a receiver for receiving a codeword of a quasi-cyclic low-density parity-check code is provided. Each component of the D-dimensional constellations encodes B bits, the codeword consists of N cyclic blocks, and each cyclic block consists of Q bits. The receiver comprises a demodulator adapted for receiving a permuted sequence of N*Q/(2B) complex-valued symbols; a cell de-interleaver adapted for applying an inverse symbol permutation to the permuted sequence of complex-valued symbols, the inverse symbol permutation being being equivalent to writing the sequence of complex-valued symbols column-wise into a matrix with Q/2 columns and N/B rows and reading out the permuted sequence of complex-valued symbols row-wise; a component de-interleaver adapted for generating N/(B*D) sequences of D*Q real-valued symbols by mapping a real part and an imaginary part of each complex-valued symbol of the sequence of N*Q/(2B) complex-valued symbols to a pair of two consecutive real-valued symbols of one of the sequences of D*Q real-valued symbols, and for applying a first symbol permutation to each sequence of real-valued symbols, the first symbol permutation being equivalent to writing the sequence of D*Q real-valued symbols row-wise into a matrix with Q columns and D rows, applying cyclic shifts to the rows of said matrix, and reading the permuted sequence of D*Q real-valued symbols column-wise from said matrix; a rotated constellation demapper adapted for dividing each permuted sequence of real-valued symbols into a plurality of D-dimensional vectors and inverse-transforming each of the D-dimensional vectors by multiplying the vector with an orthogonal matrix, resulting in N/(B*D) sequences of inverse-transformed real-valued symbols, and for de-mapping a group of B bits from each inverse-transformed real-valued symbol of each sequences of inverse-transformed real-valued symbols, resulting in N/(B*D) sections, each section consisting of B*D*Q bits; a bit de-interleaver adapted for retrieving the codeword by applying an inverse of a bit permutation to the bits of each section, wherein the bit permutation is adapted such that the Q bits of each cyclic block are mapped to Q different groups of B bits.

According to a preferred embodiment, the second symbol permutation is equivalent to writing the sequence of transformed real-valued symbols row-wise into a matrix with Q columns and N/B rows, applying cyclic shifts to the rows of said matrix, and reading the permuted sequence of transformed real-valued symbols row-wise from said matrix. In this manner, hardware complexity of both the transmitter and the receiver can be reduced substantially.

Preferably, the transformed real-valued symbols of each row are cyclically shifted by an amount of k*Q/D symbols, k being an index of the row ranging from 0 to N/B-1. In this manner, the components of each constellation are evenly spread over the entire FEC block.

Preferably, the transformed real-valued symbols of each row are cyclically shifted by an even amount symbols. In this manner, an association of pairs of real-valued symbols and complex-valued cells remains unaffected.

According to a preferred embodiment, the bit permutation is equivalent to writing the M.Q bits of each section row-wise into a matrix with Q columns and M rows and reading out the permuted bits column-wise. Such a column-row permutation allows for a particular efficient hardware implementation.

Preferably, the dimension D of the constellation is D=2 or D=4 or D=8. Further, the number of bits B encoded by each component is preferably B=1 or B=2 or B=3 or B=4.

The above and other objects and features of the present invention will become more apparent from the following description and preferred embodiments given in conjunction with the accompanying drawings, in which:
- Fig. 1A: shows a block diagram of a generic transmitter for rotated constellations;
- Fig. 1B: shows another block diagram of a generic transmitter for rotated constellations;
- Fig. 1C: shows another block diagram of a generic transmitter for rotated constellations;
- Fig. 2: illustrates a parity-check matrix of an example quasi-cyclic LDPC code;
- Fig. 3: illustrates an example bit interleaver for quasi-cyclic LDPC codes;
- Fig. 4A: illustrates row-column interleaving of the bit-interleaver sections in Fig. 3;
- Fig. 4B: is another illustration of row-column interleaving of the bit-interleaver sections in Fig. 3;
- Fig. 5: illustrates an example bit interleaver with additional QB and intra-QB permutations;
- Fig. 6A: illustrates the mapping of LDPC bits to rotated-constellation blocks;
- Fig. 6B: illustrates the construction of rotated-constellation blocks from PAM symbols;
- Fig. 7A: illustrates the mapping of interleaved bits to constellation blocks;
- Fig.7B: is a more detailed illustration of the QAM mapping step within the process of Fig. 7A;
- Fig. 7C: is a more detailed illustration of the constellation rotation step within the process of Fig. 7A;
- Fig. 8: illustrates the mapping of PAM symbols to non-rotated-constellation blocks;
- Figs. 9A-C: illustrate an example permutation performed by the component interleaver of Figs. 1A-C;
- Fig. 10A: is a schematic representation of an example output of the cell interleaver of Figs. 1A-C for D=4;
- Fig. 10B: is a schematic representation of an example output of the cell interleaver of Figs. 1A-C for D=2;
- Fig. 11: illustrates an LDPC block after component and cell interleaving;
- Fig. 12: shows a block diagram of a receiver for rotated constellations;
- Fig. 13A: shows a block diagram of an iterative decoder;
- Fig. 13B: shows a block diagram of a simplified iterative decoder according to an embodiment of the present invention; and
- Fig. 13C: shows a block diagram of an implementation detail for the component interleaver in the receiver of Fig. 12.

### DETAILED DESCRIPTION

As mentioned above, conventional component interleavers cannot be easily parallelized as their structure is not adapted to the quasi-cyclic structure of the LDPC code. The lack of parallelism prevents an efficient implementation, particularly for receivers that employ iterative decoding.

It is therefore the main goal of the invention to disclose a component interleaver that is inherently parallelizable. Moreover, the disclosed interleaver has a structure similar to that of the bit interleaver.

The inventor realized that the conventional method of mapping LDPC blocks to QAM constellations results in increased receiver complexity. The fundamental reason is the fact that the number of bits that a constellation block has from each QB of the corresponding bit-interleaver section depends on the number of rotated-constellation dimensions D. More specifically this number is 2*D, as explained above. This fact alone is not necessarily a problem. However, if the same receiver needs to support a variable number of dimensions, e.g. 1, 2, 4, and 8, the implementation efficiency would suffer. This is especially true for receivers that use iterative decoding.

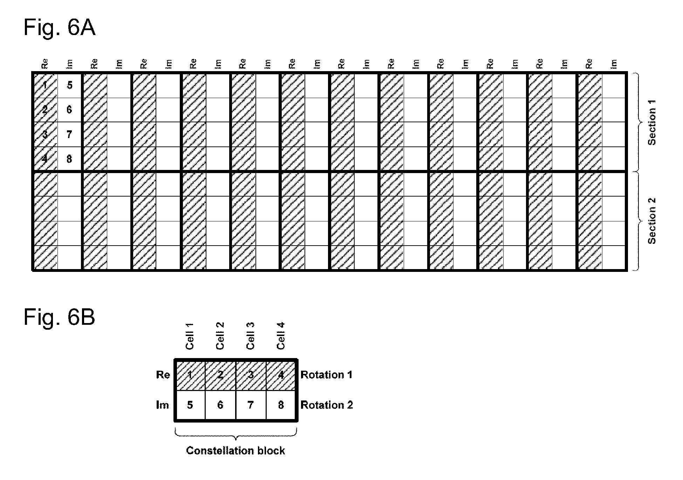

This problem can be mitigated if the mapping of the bit interleaver output to the constellation blocks is performed so that each constellation block encodes only two bits from the same QB. This is illustrated in Fig. 6A, which shows an example mapping of the LDPC bits to rotated-constellation blocks for Q=24 and D=4 (only two sections shown). The squares represent PAM symbols, 2*D PAM symbols forming a rotated-constellation block. The numbers in the squares indicate the order of the PAM symbols.

The mapping of the bits to rotated-constellation blocks comprises the steps of:
1. Mapping groups of B contiguous bits to real PAM symbols
2. Applying a first and a second rotation to the first and second group of D contiguous PAM symbols in a group of 2*D contiguous PAM symbols
3. Mapping the resulting D real symbols of the first group to D real or imaginary components of D adjacent complex cells, and mapping the resulting D real symbols to the remaining D components of said complex cells.

Preferably, the D real symbols of the first and second group are mapped to the real and the imaginary components of said complex cells, respectively. This solution is illustrated in Fig. 6B for D=4, and reflected in Figure 6A.

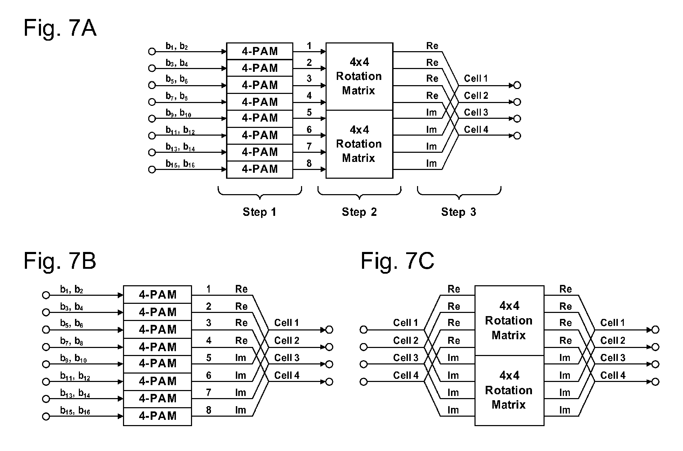

The three steps are further illustrated in Figure 7A (for B=2 and D=4), where the mapping of the 2*D real symbols to the D adjacent complex cells is performed according to the preferred option in Figure 6B. Referring to Figure 1C, these steps are performed by the "rotated constellation mapping" block.

For the purpose of the present invention, it is preferable to change the order and the grouping of the three steps illustrated in Figure 7A in order to separate the QAM mapping from the constellation rotation so that the component de-interleaver can be placed in between, as in Figure 1A. The two functions are also illustrated in Figs. 7B and 7C, respectively.

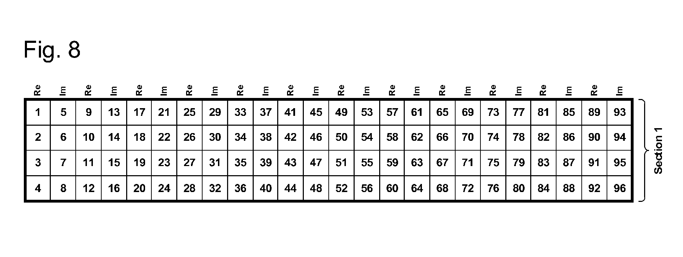

The resulting mapping of the PAM symbols to non-rotated constellation blocks is shown in Fig. 8, which is identical to Fig. 6A except for the constellation rotations and the fact that only one section is shown. Also, the grouping of 2*D PAM symbols into constellation blocks is not shown since the concept of constellation blocks does not exists in the absence of the constellation rotations.

According to the main aspect of the invention, the component interleaving is performed by applying appropriate cyclic shifts (between 0 and Q-1) to the cells of the individual rows in the above matrix, so that the D cells of each constellation block are spread as evenly as possible over the FEC block. The corresponding deinterleaving is performed by applying the exact inverse cyclic shifts to said rows. Moreover, the cyclic shifts are to be applied with cell granularity, i.e. the shifts are preferably even, i.e., a multiple of 2.

Implementing the component interleaving through cyclic shifts, as disclosed in the invention, has the advantage of a significantly reduced hardware complexity, especially in the case of receivers with iterative decoding.

Referring to Figure 1C, the component de-interleaver, which is applied to bits, can be merged into the bit interleaver thanks to their similar structure based on cyclic shifts. More concretely, the cyclic shift of each row in Fig. 6A can be added (modulo Q) to the B intra-QB cyclic shifts of the B QBs mapped to that row. Moreover, the intra-QB cyclic shifts themselves can be merged into the definition of the LDPC code, as explained above. Therefore, the component de-interleaver in the transmitter and the corresponding interleaver in the receiver require absolutely no hardware.

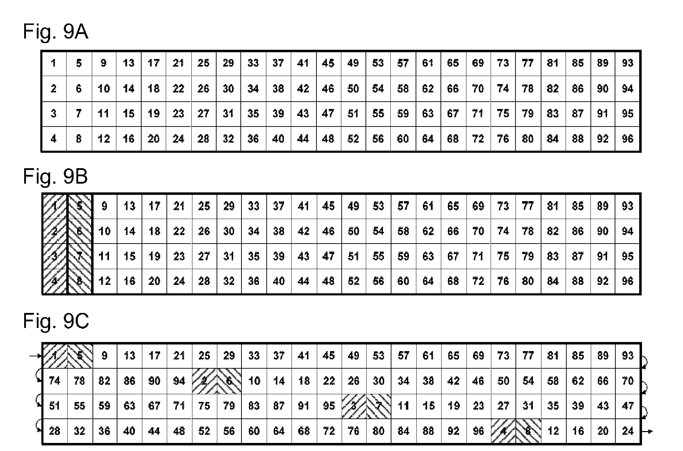

For the non-TFS case, an incremental cyclic shift of Q/D is applied to the D rows in a bit interleaver section, as illustrated in Figs. 9A to 9C for D=4. The figures show how the signal is transformed by the constellation rotation and the component interleaver in the transmitter chain shown in Figure 1A. The process is shown for only one section of the bit interleaver. In Figs. 9A and 9B the data is to be regarded as a sequence of real symbols, the matrix representation being used merely for a more compact graphic representation.

Fig. 9A shows the input real symbols, the numbers in the squares denoting their order.

Fig. 9B shows how the constellation rotation is applied to groups of D adjacent real symbols. The two kinds of hatches identify the first two rotated constellation blocks.

Fig. 9C shows the function performed by the component interleaver, comprising the steps of: writing the transformed real symbols column by column into a matrix with Q columns and D rows, applying cyclic shifts to the rows, and reading out the real symbols row by row.

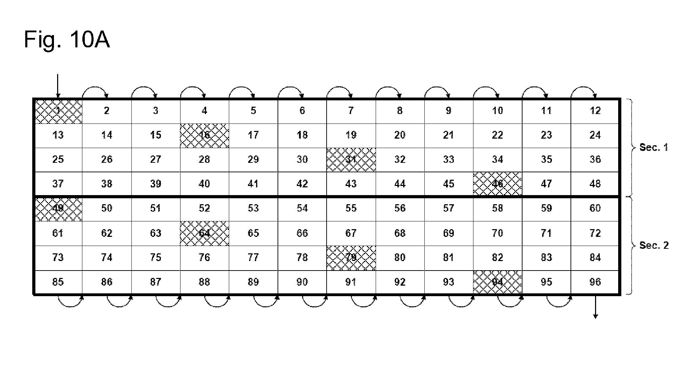

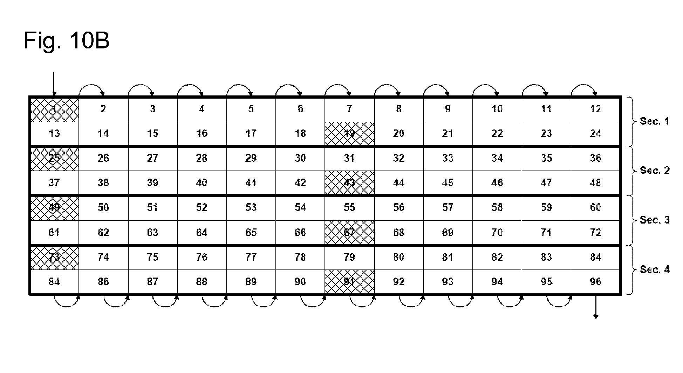

Following the component interleaving, the real symbols are mapped pairwise to complex symbols, resulting in DQ/2 symbols per bit interleaver section. The NQ/2B complex symbols of all the sections then undergo an additional complex-symbol permutation that is equivalent to: writing the symbols row by row into a matrix with Q/2 columns and N/B rows and reading them out column by column. This is illustrated in Figs. 10A and 10B for D=4 and D=2 and for two and four sections per LDPC block, respectively, for example purposes. The numbers represent the input order whereas the arrows represent the output order. For each section, the hatched rectangles identify the D symbols that carry the 2D components of the first two rotated constellations in Fig. 9 (for D=4). It can be clearly seen that the complex-symbol interleaver does not depend on the parameter D.

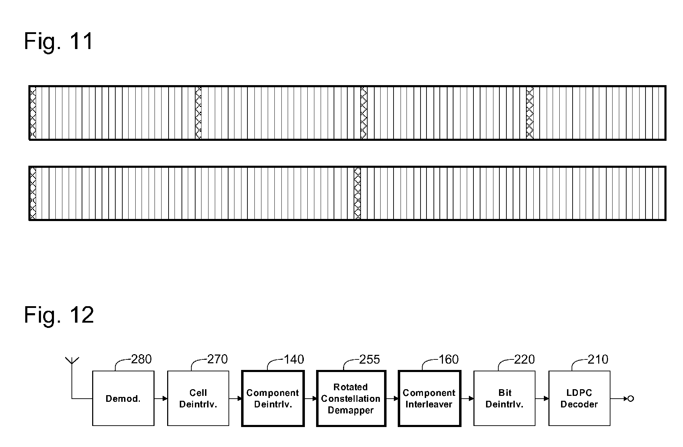

The resulting spreading of the D cells of the first constellation block is shown in Fig. 11. It can be seen that the D cells are spread very evenly over the LDPC block.

The receiver mirrors the functionality of the transmitter. The preferred block diagram for the receiver is shown in Fig. 12. Note that this diagram is the mirrored version of the transmitter in Figure 1C, in which the QAM mapper and the constellation rotation are merged into a single block, i.e., the rotated constellation mapper.

Merging the constellation de-rotation with the QAM demapper into a single block, the rotated constellation demapper 255, is necessary for taking full advantage of the rotated constellations. Implementing the two steps separately would degrade the performance significantly. These aspects are well known in the art.

In the receiver block diagram of Fig. 12 the component deinterleaver 140 is applied to complex symbols (cells), whereas the matching interleaver 160 is applied to demapped (soft) bits. As mention before for the transmitter, the cyclic shifts of the component interleaver can be merged into the cyclic shifts of the bit deinterleaver 220, which in turn can be merged into the definition of the LDPC code. The component interleaver requires therefore no hardware.

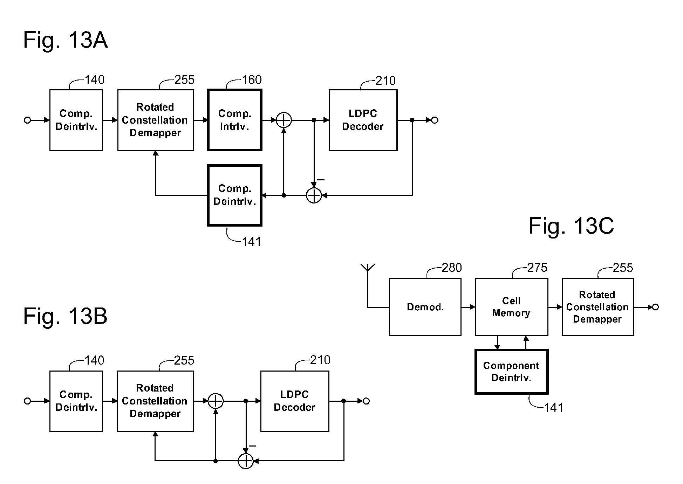

This is particularly advantageous for receivers that employ iterative decoding. The generic block diagram of such a decoder is shown in Fig. 13A. A bit interleaver and de-interleaver were not included because they require no hardware.

The essence of iterative decoding is that the demapping and the LDPC decoding are performed iteratively in a loop, the loop therefore closing over any blocks that come in between. Iterative decoding is a well-known technique and requires no further explanations.

Since the component interleaver and deinterleaver are part of the iterative decoding loop, the implementation can be greatly simplified if the component interleaver is performed according to the invention, i.e. using cyclic shifts. As mentioned before, the cyclic shifts can be merged together with the cyclic shifts of the bit interleaver into the definition of the LDPC decoder 210. Thus, no blocks come between the demapper 255 and the LDPC decoder 210, as illustrated in Fig. 13B. This enables the two blocks to be coupled more tightly, so that they can exchange data with no latency. The disclosed invention is therefore clearly superior to the conventional solution illustrated in Figure 13A.

In addition to the optimization of the iterative decoding loop, the invention also enables an efficient implementation of the component interleaver, which is outside the loop. How this can be done is illustrated in Figure 13C.

For each row in e.g. Fig. 10A or 10B, the Q/2 cells of that row are read from the cell memory, cyclically shifted according to the invention, and written back to the cell memory in place, i.e. at the same addresses they were read from. No additional memory is therefore required and the latency is very low as the interleaving is performed row by row instead of over the whole LDPC block.

## Claims

1. A method for transmitting a codeword of a quasi-cyclic low-density parity-check code in a digital communication system employing rotated D-dimensional constellations, each component of the D-dimensional constellations encoding B bits, the codeword consisting of N cyclic blocks, each cyclic block consisting of Q bits, the method comprising the steps of:
dividing the codeword into N/(B*D) sections, each section consisting of M=B*D cyclic blocks;
applying a bit permutation to the bits of each section and dividing each of the permuted sections into groups of B bits, wherein the bit permutation is adapted such that the Q bits of each cyclic block are mapped to Q different groups of B bits;
mapping each group of B bits to a real-valued symbol, resulting in a sequence of D*Q real-valued symbols for each section;
dividing each sequence of D*Q real-valued symbols into a plurality of D-dimensional vectors and transforming each of the *D*-dimensional vectors by multiplying the vector with an orthogonal matrix, resulting in a sequence of D*Q transformed real-valued symbols for each section;
applying a first symbol permutation to each sequence of D*Q transformed real-valued symbols, the first symbol permutation being equivalent to writing the sequence of D*Q transformed real-valued symbols column-wise into a matrix with Q columns and D rows, applying cyclic shifts to the rows of said matrix, and reading the permuted sequence of D*Q transformed real-valued symbols row-wise from said matrix;
generating a sequence of N*Q/(2B) complex-valued symbols by mapping each pair of two consecutive transformed real-valued symbols of each sequence of D*Q transformed real-valued symbols to a complex-valued symbol of the sequence of N*Q/(2B) complex-valued symbols;
applying a symbol permutation to the sequence of N*Q/(2B) complex-valued symbols, the symbol permutation being equivalent to writing the sequence of complex-valued symbols row-wise into a matrix with Q/2 columns and *N*/*B* rows and reading out the permuted sequence of complex-valued symbols column-wise; and
transmitting the permuted sequence of complex-valued symbols.

2. The method of claim 1, further comprising the step of applying a second symbol permutation to each sequence of D*Q real-valued symbols prior to performing the dividing step, the second symbol permutation being an inverse of the first symbol permutation.

3. The method of claim 1 or 2, wherein the transformed real-valued symbols of each row are cyclically shifted by an amount of k*Q/D symbols, k being an index of the row ranging from 0 to N/B-1.

4. The method of any of claims 1 to 3, wherein the transformed real-valued symbols of each row are cyclically shifted by an even amount symbols.

5. The method of any of claims 1 to 4, wherein the step of applying the bit permutation is equivalent to writing the M.Q bits of each section row-wise into a matrix with Q columns and M rows and reading out the permuted bits column-wise.

6. A method for receiving a codeword of a quasi-cyclic low-density parity-check code, the codeword consisting of N cyclic blocks in a digital communication system employing rotated D-dimensional constellations, each component of the D-dimensional constellations encoding B bits, each cyclic block consisting of Q bits, the method comprising the steps of
receiving a permuted sequence of N*Q/(2B) complex-valued symbols; applying an inverse symbol permutation to the permuted sequence of complex-valued symbols, the inverse symbol permutation being being equivalent to writing the sequence of complex-valued symbols column-wise into a matrix with Q/2 columns and *N*/*B* rows and reading out the permuted sequence of complex-valued symbols row-wise;
generating N/(B*D) sequences of D*Q real-valued symbols by mapping a real part and an imaginary part of each complex-valued symbol of the sequence of N*Q/(2B) complex-valued symbols to a pair of two consecutive real-valued symbols of one of the sequences of D*Q real-valued symbols;
applying a first symbol permutation to each sequence of real-valued symbols, the first symbol permutation being equivalent to writing the sequence of D*Q real-valued symbols row-wise into a matrix with Q columns and D rows, applying cyclic shifts to the rows of said matrix, and reading the permuted sequence of D*Q real-valued symbols column-wise from said matrix;
dividing each permuted sequence of real-valued symbols into a plurality of D-dimensional vectors;
de-mapping B*D bits from each D-dimensional vector, resulting in N/(B*D) sections, each section consisting of B*D*Q bits;
retrieving the codeword by applying an inverse of a bit permutation to the bits of each section, wherein the bit permutation is adapted such that the Q bits of each cyclic block are mapped to Q different groups of B bits.

7. The method of any of claims 1 to 6, wherein B=1 or B=2 or B=3 or B=4 or D=2 or D=4 or D=8.

8. A transmitter for transmitting a codeword of a quasi-cyclic low-density parity-check code in a digital communication system employing rotated D-dimensional constellations, each component of the D-dimensional constellations encoding B bits, the codeword consisting of N cyclic blocks, each cyclic block consisting of Q bits, the transmitter comprising:
a bit interleaver (120) adapted for dividing the codeword into N/(B*D) sections,
each section consisting of M=B*D cyclic blocks, and for applying a bit permutation to the bits of each section and dividing each of the permuted sections into groups of B bits, wherein the bit permutation is adapted such that the Q bits of each cyclic block are mapped to Q different groups of B bits;
a mapper (130) adapted for mapping each group of B bits to a real-valued symbol, resulting in a sequence of D*Q real-valued symbols for each section;
a constellation rotation unit (150) adapted for dividing each sequence of D*Q real-valued symbols into a plurality of *D*-dimensional vectors and transforming each of the *D*-dimensional vectors by multiplying the vector with an orthogonal matrix, resulting in a sequence of D*Q transformed real-valued symbols for each section;
a component interleaver (160) adapted for applying a first symbol permutation to each sequence of D*Q transformed real-valued symbols, the first symbol permutation being equivalent to writing the sequence of D*Q transformed real-valued symbols column-wise into a matrix with Q columns and D rows,
applying cyclic shifts to the rows of said matrix, and reading the permuted sequence of D*Q transformed real-valued symbols row-wise from said matrix;
a cell interleaver (170) adapted for generating a sequence of N*Q/(2B) complex-valued symbols by mapping each pair of two consecutive transformed real-valued symbols of each sequence of D*Q transformed real-valued symbols to a complex-valued symbol of the sequence of N*Q/(2B) complex-valued symbols, and for applying a symbol permutation to the sequence of N*Q/(2B) complex-valued symbols, the symbol permutation being equivalent to writing the sequence of complex-valued symbols row-wise into a matrix with *Q*/*2* columns and *N*/*B* rows and reading out the permuted sequence of complex-valued symbols column-wise; and
a modulator (180) adapted for transmitting the permuted sequence of complex-valued symbols.

9. The transmitter of claim 8, further comprising a component de-interleaver (140) adapted for applying a second symbol permutation to each sequence of D*Q real-valued symbols prior to performing the dividing step, the second symbol permutation being an inverse of the first symbol permutation.

10. The transmitter of claim 9, wherein the transformed real-valued symbols of each row are cyclically shifted by an amount of k*Q/D symbols, k being an index of the row ranging from 0 to N/B-1.

11. The transmitter of claim 9 or 12, wherein the transformed real-valued symbols of each row are cyclically shifted by an even amount of symbols.

12. The transmitter of any of claim 8 to 10, wherein the bit permutation is equivalent to writing the *M.Q* bits of each section row-wise into a matrix with Q columns and *M* rows and reading out the permuted bits column-wise.

13. A receiver for receiving a codeword of a quasi-cyclic low-density parity-check code, the codeword consisting of N cyclic blocks in a digital communication system employing rotated D-dimensional constellations, each component of the D-dimensional constellations encoding B bits , each cyclic block consisting of Q bits, the receiver comprising:
a demodulator (280) adapted for receiving a permuted sequence of N*Q/(2B) complex-valued symbols;
a cell de-interleaver (270) adapted for applying an inverse symbol permutation to the permuted sequence of complex-valued symbols, the inverse symbol permutation being being equivalent to writing the sequence of complex-valued symbols column-wise into a matrix with *Q*/*2* columns and *N*/*B* rows and
reading out the permuted sequence of complex-valued symbols row-wise;
a component de-interleaver (140) adapted for generating N/(B*D) sequences of D*Q real-valued symbols by mapping a real part and an imaginary part of each complex-valued symbol of the sequence of N*Q/(2B) complex-valued symbols to a pair of two consecutive real-valued symbols of one of the sequences of D*Q real-valued symbols, and for applying a first symbol permutation to each sequence of real-valued symbols, the first symbol permutation being equivalent to writing the sequence of D*Q real-valued symbols row-wise into a matrix with Q columns and D rows, applying cyclic shifts to the rows of said matrix, and reading the permuted sequence of D*Q real-valued symbols column-wise from said matrix;
a rotated constellation demapper (255) adapted for dividing each permuted sequence of real-valued symbols into a plurality of *D*-dimensional vectors and for de-mapping B*D bits from each D-dimensional vector, resulting in N/(B*D) sections, each section consisting of B*D*Q bits;
a bit de-interleaver adapted for retrieving the codeword by applying an inverse of a bit permutation to the bits of each section, wherein the bit permutation is adapted such that the Q bits of each cyclic block are mapped to Q different groups of B bits.
